# EUROPEAN PATENT SPECIFICATION

(11) **EP 0 817 550 B1**
(45) Date of publication and mention of the grant of the patent: **12.05.1999**
(21) Application number: 97109791.0
(22) Date of filing: 16.06.1997
(51) Int. Cl.: H05K 3/30

(54) **Circuit board with improved positioning means**
Leiterplatte mit verbesserten Positionierungsmitteln
Plaquette de circuit imprimé avec des dispositifs de positionnement améliorés

(30) Priority: 26.06.1996 JP 165992/96
(43) Date of publication of application: 07.01.1998
(73) Proprietor: NGK Spark Plug Co. Ltd., Nagoya-shi Aichi-ken 467 (JP)
(72) Inventor: Murata, Haruhiko, Mizuho-ku, Nagoya-shi, Aichi 467 (JP); Kimura, Yukihiro, Mizuho-ku, Nagoya-shi, Aichi 467 (JP)
(74) Representative: Grünecker, Kinkeldey, Stockmair & Schwanhäusser Anwaltssozietät

(56) References cited:
- US-A- 4 688 867
- US-A- 5 561 328
- DATABASE WPI Section PQ, Week 9613 Derwent Publications Ltd., London, GB; Class P56, AN 96-126391 XP002043935 & JP 08 023 197 A (ASAKA DENSHI KK) , 23 January 1996
- DATABASE WPI Section EI, Week 9331 Derwent Publications Ltd., London, GB; Class V04, AN 93-246532 XP002043936 & JP 05 167 296 A (MATSUSHITA ELEC IND CO LTD) , 2 July 1993
- DATABASE WPI Section EI, Week 9615 Derwent Publications Ltd., London, GB; Class V04, AN 96-148903 XP002043937 & JP 08 037 397 A (FUJIKURA LTD) , 6 February 1996
- PATENT ABSTRACTS OF JAPAN vol. 010, no. 162 (P-466), 10 June 1986 & JP 61 015289 A (MITSUBISHI JUSHI KK), 23 January 1986,

## Description

### 1. Field of the Invention

The present invention relates in general to a circuit board such as a wired board or substrate for mounting thereon a flip chip or the like, and more specifically to a circuit board with an improved positioning means for positioning a flip chip or the like electronic device in place thereon. The present invention further relates to a method of manufacturing such a circuit board. The present invention still further relates to an assembly of such a circuit board and a mounted board such as a flip chip or the like electronic device mounted on the circuit board and a method of producing such an assembly.

### 2. Description of the Related Art

The term "circuit board" is herein used to indicate a wired board or substrate for mounting thereon a flip chip or the like electronic device and encompass a printed circuit board, motherboard, etc.

Bonding of a flip chip to a circuit board has heretofore been made by the following steps.

Firstly, as shown in Fig. 8A, flux P4 is applied in such a way as to cover and embed therein solder bumps P3 which are formed on conduction pads of a circuit board P1 or on conduction pads of a flip chip P5. Such application of the flux P4 is made for the purpose of preventing movement of the flip chip P5 out of place before melting of the solder bumps P3 and improving the bonding ability.

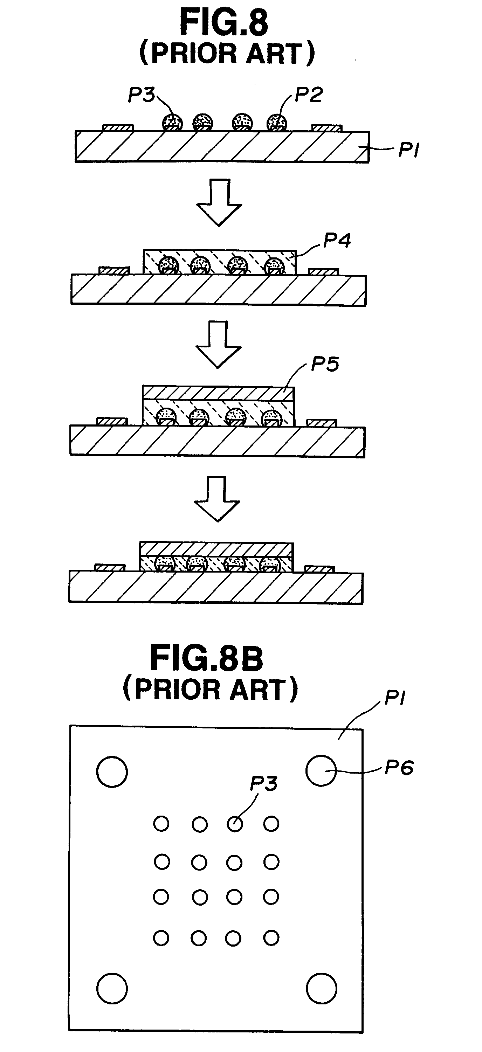

Then, alignment marks P6 provided to the circuit board P1 (refer to Fig. 8B) and the external shape of the flip chip P5 are read by means of an image processor, so that based on the thus read information a device is used to position the flip chip P5 in a predetermined place on the circuit board P1.

Then, the solder bumps P3 are heated to melt to bond the flip chip P5 and the circuit board P1 together.

However, bonding of the flip chip P5 to the circuit board P1 in the above described manner encounters the following problems and a countermeasure for solving the problems has eagerly been desired.
(1) A costly image processor is necessitated for positioning of the flip chip P5. Further, such positioning that is carried out by image processing, requires much time.
(2) The relation between the alignment mark P6 and the mounted position of the flip chip P5 needs to be input to (i.e., learnt by) a positioning device, causing a difficult set-up.
(3) There may occur such a case in which the alignment mark P6 cannot be recognized or processed by an image processor due to a surface condition, i.e., in case the luster of the plating is too high or too bright, or discoloration is caused due to rusting.
(4) Though the flip chip P5 is fixed temporarily by using the adherence strength of the flux P4 and thereby prevented from movement out of place, there may occur such a case in which the flip chip P5 is moved or displaced out of place due to vibrations during conveyance since the adherence strength of the flux P4 is weak or not so large.
(5) Since the flux P4 is applied to prevent movement of the flip chip P5 before melting of the solder bumps P3, it is needed to remove the flux P4 by cleaning after the melting of the solder bumps P3. However, there is a difficulty in carrying out such a cleaning since the distance between the circuit board P1 and the flip chip P5 is so small. Further, if some flux P4 remains unremoved, corrosion may be caused or subsequent resinous molding may become incomplete, thus lowering the reliability.

### SUMMARY OF THE INVENTION

According to an aspect of the present invention, there is provided a circuit board which comprises a substrate having a main surface, a plurality of bonding pads disposed on the main surface of the substrate for connection with terminal pads of a mounted board to be mounted on the substrate, and a plurality of projections disposed on the main surface of the substrate for controlling a position of a side surface of the mounted board and thereby positioning the mounted board in a predetermined place on the substrate.

The term "mounted board" is herein used to indicate a wired board or substrate which is to be mounted on the circuit board and encompasses an integrated circuit board, a semiconductor element substrate, and a circuit board having mounted thereon an integrated circuit chip or the like. Further, the side surface of the mounted board is intended to indicate the side or sides other than the front and rear sides of the mounted board, specifically the side surface or the surfaces constituting the outer periphery of the mounted board, or the side surface or the surfaces constituting the inner periphery of a hole in case the mounted board is formed with the hole.

According to this aspect, the circuit board is provided with positioning projections for positioning the mounted board in place. Accordingly, when the mounted board is mounted on the circuit board, the mounted board can be positioned in place with ease through control of the position of the side surface of the mounted board by means of the positioning projections. Further, it becomes possible to prevent movement of the mounted board during conveyance, so the mounted board can be bonded to the circuit board with accuracy.

According to another aspect of the present invention, the side surface of the mounted board comprises an external side surface at the periphery of the mounted board.

According to this aspect, the circuit board is provided with the projections adapted to control the position of the external side surface of the mounted board. Accordingly, in case the mounted board is mounted on the circuit board, it is first conducted, for example, to move the mounted board while holding it inclined until one end of the mounted board abuts upon corresponding projections. When the end of the mounted board has come to abut upon the corresponding projections, the mounted board is put down while being held engaged at that end with the projections. By this, the mounting work of the mounted board can be done considerably with ease.

According to a further aspect of the present invention, at least one of a group of the terminal pads of the mounted board and a group of the bonding pads of the circuit board are provided with solder bumps, respectively.

The solder herein used for the solder bumps can be, other than Pb-Sn soft solder, Au-Sn alloy, Au-Si alloy or the like that is normally used as a material for solder bump and that has a melting point of 450 °C or less and is considered in a broad sense as solder.

According to this aspect, the terminal pads of the mounted board or the bonding pads of the circuit board are provided with the solder bumps. Accordingly, by carrying out the alignment or positioning by means of the projections and thereafter melting the solder bumps by heating, the terminal pads of the mounted board and the bonding pads of the circuit board can be electrically connected while being joined together with solder.

According to a further aspect of the present invention, the projections are made of solder.

The projections can be made of the same solder as the above described solder bump.

In the meantime, in case the melting point of the projections and the solder bumps are equal in the melting point to each other, the projections are caused to melt when the solder bumps are melted to bond the mounted board, thus not causing any obstruction to an self-alignment action of the mounted board. This is the same when the melting point of the projections is low. On the other hand, when the melting point of the projections is high, movement of the mounted board is prevented assuredly until the projections are melted.

According to this aspect, the projections are made of solder. Accordingly, the projections can be used in such a way as to make the best use of the characteristics of solder.

Specifically, since the solder is soft, the mounted board can be mounted in place on the circuit board by being pushed in among or amid the projections though the distance between the opposite projections is a little smaller than a predetermined value (i.e., the projections disposed on the opposite sides of the circuit board). Further, since the solder is melted by heating, the projections can be melted at the time of bonding by means of the solder bumps. When the solder bumps are melted to be joined with the corresponding pads, the mounted board is acted upon by a self-alignment action and is urged to move by the effect of the surface tension in such a way that each matching pair of terminal pad and bonding pad which are positioned opposite to each other, are aligned with each other. In this instance, when the projections are melted similarly to the solder bumps, they do not cause any obstruction to the above movement of the mounted board, thus making it possible to bond the terminal pads and the bonding pads in such a way as to make a matching pair of pads be aligned with each other. On the other hand, when the projections are not melted, movement of the mounted board does not occur even when large vibrations are caused during melting of the solder bumps, similarly to the case the projections are made of a resinous material.

According to a further aspect of the present invention, the projections are made of a resinous material and formed by means of a photolithographic technology.

The photolithographic technology is herein used to indicate a technology for forming a resin layer of a desired pattern by subjecting photosensitive resin to exposure and development.

According to this aspect, the projections are made of resin that is shaped by means of a photolithographic technology. Accordingly, it becomes possible to set or determine the shape and the positions of the projections with accuracy.

According to a further aspect of the present invention, the mounted board is a flip chip and the circuit board is of the kind for mounting thereon a flip chip.

According to a further aspect of the present invention, the mounted board is a LGA board or a BGA board having mounted thereon a flip chip, and the circuit board is a printed circuit board.

Herein, the term " LGA board" is used to indicate a land grid array board or substrate on which bonding pads (lands) are arranged in a way as to from a grid pattern. Further, the term "BGA board" is used to indicate a ball grid array board or substrate which is a modified LGA board or substrate having solder balls on the bonding pads.

According to a further aspect of the present invention, the mounted board is nearly rectangular when observed in a plan view and at least two of the projections are disposed to each side of the mounted board.

According to this aspect, the mounted board can be positioned in place with ease and mounted on the circuit board, by moving the mounted board which is for example rectangular while holding it abutted at its one end upon the corresponding projections. Further, movement of the mounted board in a rotational direction can be prevented with ease.

According to a further aspect of the present invention, there is provided a method of making a circuit board, which comprises the steps of preparing a circuit board including a substrate having a main surface, a plurality of bonding pads disposed on the main surface of the substrate for connection with terminal pads of a mounted board to be mounted on the substrate, forming a photosensitive resin layer on the main surface of the substrate, and after the step of the forming, treating the photosensitive resin layer by an exposure process and a development process and forming a plurality of projections made of resin for controlling a position of a side surface of the mounted board and thereby positioning the mounted board in a predetermined place on the circuit board. By this, the projections can be formed with ease, and the shape and the positions of the projections can be set or determined with accuracy.

According to a further aspect of the present invention, there is provided a method of making a circuit board, which comprises the steps of preparing a circuit board having a main surface, forming on the main surface of the circuit board a plurality of bonding pads for connection with terminal pads of a mounted board to be mounted on the circuit board, and a plurality of projection pads for forming thereon projections for controlling a position of a side surface of the mounted board and thereby positioning the mounted board in a predetermined place on the substrate, disposing, after the step of said forming, masses of solder on the bonding pads, respectively, and after the step of the disposing, melting the masses of solder by heating and forming solder projections on the projection pads, respectively.

Herein, the temperature at which the solder (e.g., the solder which the solder bumps are made of) is heated to melt can be equal to or higher than the melting point of the solder, for example, can be higher than the melting point by 10 to 40 °C.

According to this aspect, the solder projections can be formed with ease by a usual or conventional means for forming solder bumps.

According to a further aspect of the present invention, the method of making a circuit board, further comprises the step of disposing masses of solder on the bonding pads, respectively and forming solder bumps on the bonding pads by heating and melting the masses of solder simultaneously with the forming of the solder projections on the projection pads. By this, the solder bumps for bonding and the solder projections for positioning can be formed by simultaneous heating or heating at one time, thus making it possible to simplify the manufacturing steps.

According to a further aspect of the present invention, there is provided a method of making a circuit board, which comprises the steps of preparing a circuit board having a main surface, forming on the main surface of the circuit board a plurality of bonding pads for connection with terminal pads of a mounted board to be mounted on the circuit board, and a plurality of projection pads for forming thereon projections for controlling a position of a side surface of the mounted board and thereby positioning the mounted board in a predetermined place on the substrate, preparing an intaglio plate having a plurality of depressions at corresponding positions to projection pads and the terminal pads, filling the depressions of the intaglio plate with solder paste and placing the intaglio plate on the main surface of the circuit board in such a way that the depressions are aligned with the projection pads and the bonding pads, and after the step of the placing, melting the solder paste by heating and forming solder projections made on the projection pads while forming solder bumps on the bonding pads. By this, the solder bumps and the solder projections can be formed simultaneously. Further, by making the depressions differ in shape, the solder bump and solder projection which differ in size or dimensions can be formed simultaneously. In the meantime, by making each solder bump have a flattened top through adjustment of the shape of the depression when the solder bumps are to be formed, the bonding ability of the matching pair of pads can be improved.

According to a further aspect of the present invention, there is provided an assembly of a circuit board and a mounted board, wherein the mounted board is bonded to the main surface of the circuit board after being positioned in place by the projections and constitutes an integral unit with the circuit board. By this, in the assembly of the circuit board and the mounted board there is not caused any misalignment of the matching pads with each other, so the matching pads are bonded with accuracy and high reliability.

According to a further aspect of the present invention, there is provided a method of making an assembly of a circuit board and a mounted board, wherein the mounted board is mounted on the main surface of the circuit board while being aligned with the circuit board by means of the projections, and then the bonding pads of the circuit board and the terminal pads of the mounted board are bonded together. By this, an assembly of a circuit board and a mounted board can be manufactured with ease and with accuracy.

According to a further aspect of the present invention, there is provided a method of making an assembly of a circuit board and a mounted board, which comprises the steps of mounting the mounted board on the main surface of the circuit board while aligning the mounted board with the circuit board by means of the projections, melting, after the step of said mounting, the solder bumps formed on at least one of the circuit board and the mounted board, by heating, and bonding the bonding pads of the circuit board and terminal pads of the mounted board together. By this, movement of the mounted board is prevented by the projections, so movement of the mounted board during conveyance never occurs, and the circuit board and the mounted board can be bonded together under an accurately positioned condition by heating and melting the solder bumps.

According to a further aspect of the present invention, there is provided a method of making a circuit board and a mounted board, wherein the projections are made of solder and melted at the same time when the solder bumps are melted. Since the projections are melted at the time of melting of the solder bumps, the projections do not cause any obstruction to movement of the mounted board for the self-alignment action thereof. The matching pair of terminal pad and bonding pad are thus movable so as to be aligned with each other by the effect of the surface tension at the time of bonding by the solder bumps, thus making it possible to correct misalignment by that movement.

According to a further aspect of the present invention, there is provided a method of making an assembly of a circuit board and a mounted board, wherein the heating is performed in a nonoxidizing atmosphere. By this, the solder, pads, etc. are not oxidized, thus making it possible to attain an improved durability.

According to a further aspect of the present invention, there is provided a method of making an assembly of a circuit board and a mounted board, wherein the bonding of the bonding pads and the terminal pads is performed without interposing therebetween flux or solder paste containing flux. By this, removal of the flux after bonding becomes unnecessary, thus making it possible to manufacture the assembly more easily.

The above structure and method are effective for solving the above noted problems inherent in the prior art.

It is accordingly an object of the present invention to provide a novel and improved circuit board which a flip chip or the like can be aligned with and bonded to with ease and accuracy.

It is a further object of the present invention to provide a method of making such a circuit board of the foregoing character.

It is a still further object of the present invention to provide an assembly of a circuit board of the foregoing character and a mounted board.

It is a yet further object of the present invention to provide a method of making such an assembly.

### BRIEF DESCRIPTION OF THE DRAWINGS

Fig. 1A is a perspective view of a circuit board with solder bumps and positioning projections according to an embodiment of the present invention;
Fig. 1B is an enlarged, fragmentary sectional view of the circuit board of Fig. 1A;
Fig. 2 is an illustration of a process of forming the positioning projections of Fig. 1A;
Fig. 3 is an illustration of a process of forming the solder bumps of Fig. 1A;
Fig. 4 is an illustration of a process of mounting a flip chip on the circuit board of Fig. 1A;
Fig. 5 is an illustration of a process of forming positioning projections and bonding pads according to another embodiment of the present invention;
Fig. 6 is an illustration of a process of forming solder bumps on the positioning projections and the solder bumps of Fig. 5;
Fig. 7 is an illustration of a process of mounting a flip chip on the solder bumps of Fig. 6; and
Fig. 8 is an illustration of a prior art.

### BRIEF DESCRIPTION OF THE PREFERRED EMBODIMENTS

Hereinafter, description will be made as to a circuit board having a substrate made of resin or a resinous material for mounting thereon by face down bonding an integrated circuit chip (e.g., a LSI element and will be referred to hereinafter as flip chip). In other words, description will be made to a circuit board for bonding thereto a flip chip by a flip chip technology. Description will further be made as to a method of making such a circuit board, an assembly of such a circuit board and a mounted board such as a flip chip, and a method of making an assembly of a circuit board and a mounted board.

### (First embodiment)

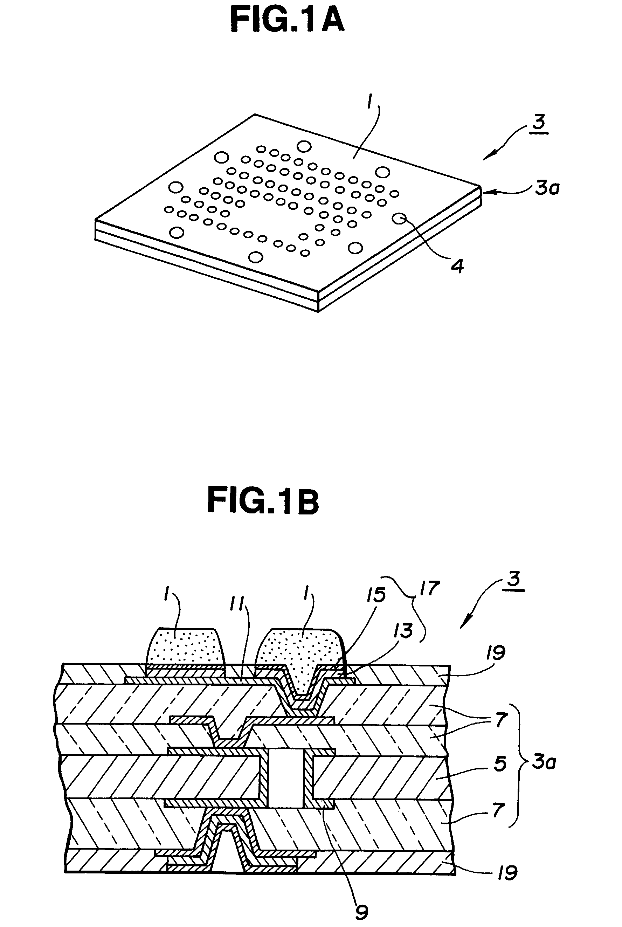

Referring first to Figs. 1 to 4, a first embodiment will be described. A circuit board of this embodiment is generally indicated by 3 and provided with positioning projections 4 made of resin or a resinous material.

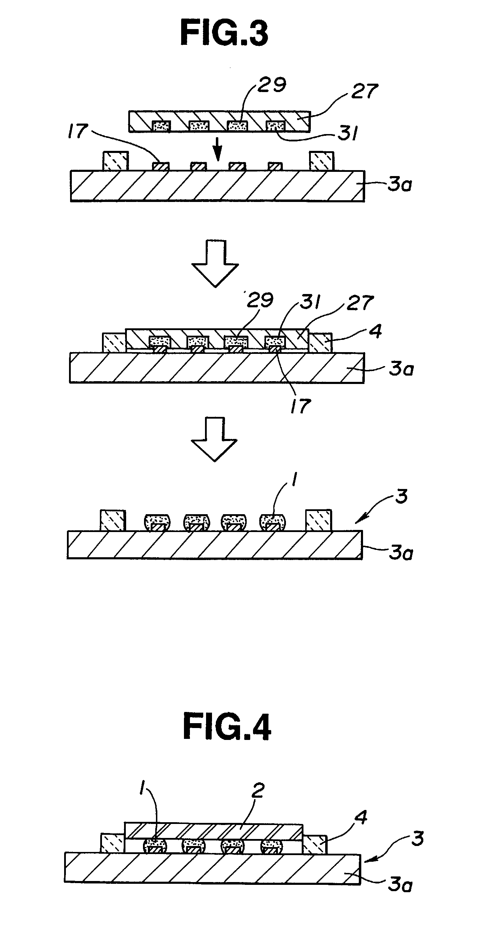

The circuit board 3 includes a multi-layered substrate 3a which is about 25 mm square, about 1 mm thick and made of a resinous material. The substrate 3a has on one side surface (i.e., an upper surface in Fig. 1A) a number of solder bumps 1 which are each about 150 µm in diameter and 60 µm high and used for bonding a flip chip 2 (refer to Fig. 4) to the substrate 3a.

Further, on the upper surface of the substrate 3a and in the area around the above described number of solder bumps 1, there are disposed positioning projections 4 which are each 0.8 mm in diameter and 0.4 mm high, two of which are disposed to every side of the flip chip 2 and which are eight in total, i.e., in a way as to correspond to the external shape of the flip chip 2. In the meantime, the flip chip 2 to be bonded to the substrate 3a is 12.5 mm x 18 mm in external shape and 0.4 mm thick, and made of silicon (Si).

Hereinafter, a method of making a circuit board 3 having positioning projections 4 will be described in detail.

### (a) Process of making Circuit Board 3

(1) The circuit board 3 is prepared so as to have such a structure shown in Fig. 1B, i.e., insulation layers 7 made of epoxy resin are formed and laminated one upon antoher on a BT (bismaleimide triazine) resin core layer 5 to constitute the substrate 3a while the insulation layers 7 and the BT core layer 5 being formed with Cu inner conductive pathways 9 passing therethrough by a semi-additive process using a Cu electroless plating. In the meantime, the process of forming the Cu inner pathways 9 can be a subtractive process or a full additive process.
(2) Then, on the outermost surface of the substrate 3a, an about 3 µm thick Ni-P layer 13 is formed by Ni-P electroless plating for a Cu conductive pathway 11 joined with the Cu inner conductive pathways 9 to be resistant to corrosion and for improving the adhering ability of the same. Further on the Ni-P layer 13, an about 0.1 µm thick Au layer 15 is formed by Au electroless plating for thereby constituting a base conductive pad (hereinafter referred to only as bonding pad) 17 consisting of the Ni-P layer 13 and the Au layer 15. In the meantime, in other places, a solder resist layer 19 of acrylic resin or epoxy resin is formed.

In the meantime, the above described plating process is the same as a well-known plating process used for a multi-layer printed circuit board as for example disclosed in "365 steps for Multi-layer Printed Circuit Board" written by Fujihira and Fujimori and published by Association of Industrial Research, so the detailed description thereto is omitted for brevity.

### (b) Process of forming Positioning Projections 4

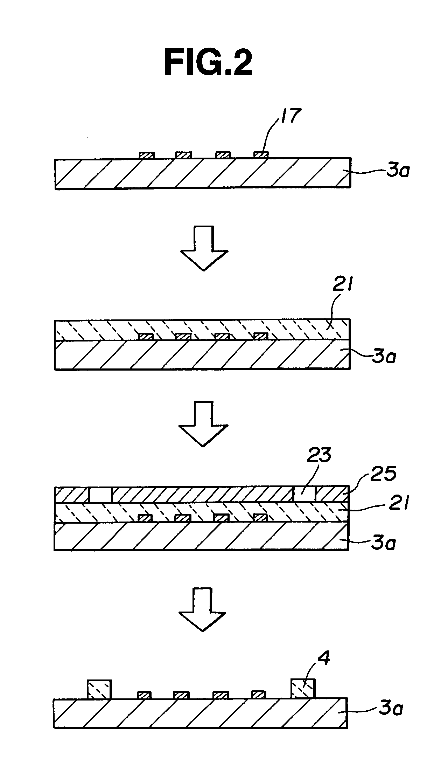

(1) As schematically shown in Fig. 2, known photosensitive epoxy resin such as provy-coat 5000 (trade name) of Nihon Paint Co. make is applied in a way as to cover all the upper surface of the substrate 3a (i.e., the surface including the bonding pads 17) and so as to be 0.4 mm thick, whereby to constitute a photosensitive epoxy resin layer 21.
(2) Then, an exposure mask 25 having holes 23 only at projection forming portions is placed on the photosensitive epoxy resin layer 21, and only the projection forming portions of the photosensitive epoxy resin layer 21 are exposed to ultraviolet rays.
(3) Thereafter, the superfluous resin is removed by development, whereby the positioning projections 4 made of resin are formed. In the meantime, when this is the case, the accuracy of the positions at which the positioning projections 4 are formed is determined depending upon the accuracy of the positioning or alignment between the exposure mask 25 and the circuit board 3.

### (c) Process of forming Solder Bumps 1

Since the positioning projections 4 are provided on the substrate 3a, there is a difficulty in carrying out the process of applying solder on the bonding pads 17 by employing a normal printing technology. Thus, in this embodiment, a technology using an intaglio plate is employed. An example of a technology using an intaglio plate is disclosed in Japanese patent application No. 8-94314. This technology makes it possible to obtain solder bumps 1 having flattened tops, therefore of a small coplanarity and being excellent in bonding ability.
(1) Firstly, as schematically shown in Fig. 3, an intaglio plate 27 having depressions 29 each of which is 0.25 mm in diameter and 0.15 mm deep is used. The depressions 29 are filled with eutectic solder paste 31 of the melting point of 183 °C by squeeze.
(2) Then, the intaglio plate 27 is placed on the circuit board 3 in a way as to be aligned at the depressions 29 with the bonding pads 17. In this instance, by determining the size of the intaglio plate 27 to be 12.5 mm x 18 mm similarly to the flip chip 2, the intaglio plate 27 can be fittingly placed on the circuit board 3 without hitting against the positioning projections 4, and furthermore the provision of the positioning projections 4 makes it possible to attain both positioning and fixing of the intaglio plate 27 simultaneously.
(3) Then, the intaglio plate 27 and the circuit board 3 under this condition is made to pass through a reflow furnace (not shown) of the maximum temperature of 220 °C to melt the solder paste 31 and thereafter cooled. After that, by removing the intaglio plate 27 from the circuit board 3, the solder bumps 1 for mounting thereon a flip chip are formed.

### (d) Process of mounting Flip Chip

(1) As schematically shown in Fig. 4, a flip chip 2 is set manually or by using a machine in the place surrounded by the positioning projections 4. In this instance, the flip chip 2 is restricted at four sides in lengthwise and widthwise movement by means of the positioning projections 4, and therefore movement of the flip chip 2 out of place never occurs. Further, since two positioning projections 4 are provided to each side, rotational movement can also be prevented. In this connection, for prevention of such rotational movement, it will suffice to provide at least two positioning projections to each side. In the meantime, flux is not applied between the flip chip 2 and each solder bumps 1.
(2) Then, nitrogen gas is passed into the reflow furnace at the rate of 8 cm³/Hr, while the maximum temperature is held at

220 °C. Under this condition, the circuit board 3 having mounted thereon the flip chip 2 is passed through the furnace. By this, the solder bumps 1 are made to melt and bond the circuit board 3 and the flip chip 2 together. That is, the bonding pads 17 of the circuit board 3 and terminal pads (not shown) of the flip chip 2 are bonded by means of the solder bumps 1.

In the meantime, in order to assuredly dispose the flip chip 2 between the positioning projections 4 which are disposed to oppose lengthwise and widthwise of the flip chip 2, it is desirable, on consideration of the accuracy of the positions of the positioning projections 4, to provide a clearance of about 30 µm between the flip chip 2 and each positioning projection 4.

In this manner, the positioning projections 4 are made of a resinous material in this embodiment, so it becomes possible to carry out the alignment or positioning of the flip chip 2 without using the alignment mark and the image processor which have been necessitated in the prior art, thus being capable of producing the following effects.
(1) A costly image processor for the alignment or positioning of the flip chip 2 can be dispensed with. Further, since the alignment or positioning is carried out by using the positioning projections, the alignment or positioning can be done in less time as compared with the case where image processing is carried out.
(2) It is not necessary to input the relation between the alignment mark and the position at which the flip chip 2 is mounted to a positioning device, individually with respect to each article number, so the working step can be simplified from this point of view.
(3) Since the alignment mark is not used, it is needless to say that there does not occur such a problem on whether it is possible or not to carry out image processing.
(4) Since application of flux before melting of the solder bumps 1 for preventing movement of the flip chip 2 as in the prior art is not made but the alignment of the flip chip 2 is made by using the positioning projections 4, movement of the flip chip 2 due to vibrations during conveyance never occurs.
(5) Since flux is not used, the process of removing the flux by cleaning after the melting of the solder bumps 1 can be dispensed with. Further, though the distance between the circuit board 3 and the flip chip 2 is small, there is not any flux remains unremoved since flux is not used in this embodiment but resinous molding can be done perfectly and there is not caused any rusting, thus improving the reliability.
(6) Particularly, since the positioning projections 4 are made of resin, they do not deform even during melting of the solder bumps 1, so the flip chip 2 is not moved out of place even when subjected to considerably large vibrations during melting of the solder bumps 1.

### (Second Embodiment)

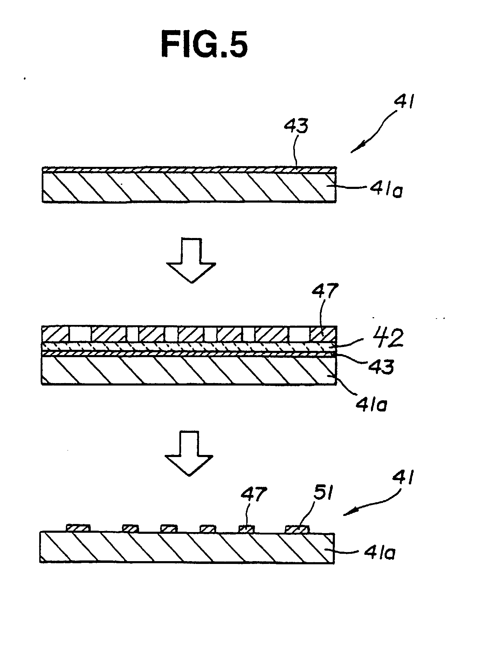

Referring to Figs. 5 to 7, the second embodiment will be described. In this embodiment, the positioning projections are formed by solder bumps. In the meantime, similar explanation to that of the above described first embodiment is omitted for brevity.

### (a) Process of forming Circuit Board 41

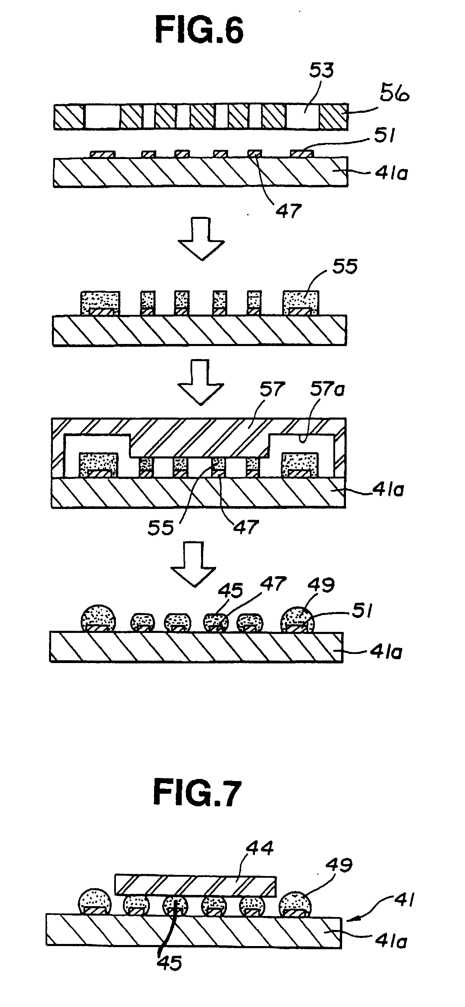

(1) By using similar materials to those of the above described first embodiment and by employing a similar process to the above described (a) Process of forming Circuit Board, Cu inner pathways are formed within the substrate 41a.
(2) Then, as schematically shown in Fig. 5, a Cu plated layer 43 is formed all over the upper surface of the substrate 41a by means of electroless Cu plating or Cu electroplating.
(3) Thereafter, known photosensitive etching resist 42 is applied over the Cu plated layer 43, an exposure mask 47 is placed on the etching resist 42, and exposure and development are carried out.
(4) Then, a superfluous Cu plated layer portion is removed by etching, thereafter the circuit board 41 is electroless Ni-P plated and then electroless Au plated, so that there are formed simultaneously bonding pads 47 (of 150 µm in diameter) for forming thereon solder bumps 45 (refer to Fig. 6) which are used for bonding a flip chip 44 (refer to Fig. 7) to the circuit board 41, and positioning pads 51 (of 800 µm in diameter) for forming thereon positioning solder bumps 49 (refer to Fig. 6).

That is, by a subtractive technology the bonding pads 47 and the positioning pads 51 which are made of Cu are formed simultaneously. In the meantime, in place of the subtractive technology a semi-additive technology or a full additive technology can be used.

### (a) Process of forming Solder Bumps 45, 49

In this embodiment, a solder paste printing technology is used as a method of applying solder bumps on the pads 47 and 51, though there can be used in place therefor various other technologies such as solder ball mounting technology, solder preform mounting technology, and solder paste dispenser technology. In the meantime, in case of the solder ball mounting technology and the solder preform mounting technology, two kinds of solder balls which are different in size or dimensions are needed for forming small bumps (bonding solder bumps 45) for bonding thereto a flip chip and large bumps for positioning (positioning solder bumps 49), and furthermore two kinds of size of solder bumps cannot be placed simultaneously on the pads 47 and 51 by means of a machine, thus causing a bad workability. In case of the solder paste dispenser technology, it is necessary to drop solder paste of the amount for one bump each time of forming each bump, thus causing a poor workability. Accordingly, it is preferable to use a solder paste printing technology or a technology using an intaglio plate jig as shown in the first embodiment.
(1) As schematically shown in Fig. 6, a metal mask 56 of 70 µm thick and having holes 53 of 0.2 mn in diameter (for bonding solder bump) and 1.0 mm in diameter (for positioning solder bump) at predetermined positions, is disposed in such a way that the holes 53 are aligned with the corresponding bonding pads 47 and positioning pads 51, respectively.
(2) Then, similar eutectic solder paste to that of the first embodiment is applied by printing to form eutectic solder paste layers 55 on the bonding pads 47 and the positioning pads 51, respectively.
(3) Then, a flattening jig 57 such as one that is disclosed in Japanese patent application No. 8-76950 is placed on the eutectic solder paste layer 55. That is, the flattening jig 57 disposed in place so as to push the upper end portions of the eutectic solder paste layers 55 formed on the bonding pads 47. In the meantime, the flattening jig 57 is formed with depressions 57a so as not to push the eutectic solder paste layers 55.
(4) Under this condition, the flattening jig 57 and the circuit board 41 is let to go through a reflow furnace of the maximum temperature of 220 °C to melt the eutectic paste, and after the solder paste is cooled the flattening jig 57 is removed. By this, the solder bumps 45 for mounting thereon a flip chip and having flattened tops are formed on the bonding pads 47 and at the same time the positioning solder bumps 49 which constitute positioning projections having rounded tops are formed.

### (b) Process of mounting Flip Chip 44

(1) As schematically shown in Fig. 7, the flip chip 44 is set manually or by means of a machine in the place surrounded by the positioning solder bumps 49.
(2) Then, under the condition in which nitrogen gas flows at the rate of 8 m³/Hr within the reflow furnace and the maximum temperature is maintained at 220 °C, the circuit board 41 having mounted thereon the flip chip 44 is let to go through the furnace. By this, the bonding solder bumps 45 and the positioning solder bumps 49 are melted simultaneously to bond the circuit board 41 and the flip chip 44 together.

In this manner, the projections (positioning solder bumps 49) for positioning of the flip chip 44 are made of solder, so the alignment of the flip chip 44 with the circuit board 41 can be attained without using such an alignment mark and an image processor as necessitated in the prior art and therefore this embodiment can produce substantially the same effects (1) to (5) as the first embodiment.

Particularly, in this embodiment, the projections are made of solder which is softer than the resin, so the flip chip 44 can be pushed into the space surrounded by the projections and be disposed in place on the circuit board 41 without providing any clearance between each positioning solder bump 49 and the flip chip 44.

Further, in case of using the solder paste printing technology using eutectic solder paste and the technology using an intaglio plate jig, the solder projections can be formed by the conventional process steps if the printing mask used and the intaglio pattern are modified, so the cost increases by only the amount corresponding to the increased quantity of solder.

Further, in case the projections are made of resin, there is a possibility of the positional accuracy of the projections being deteriorated if there is a difference in position (i.e., misalignment) between the time when the exposure for forming bonding pads is performed and the time when the exposure for forming the projections made of resin is performed. However, in case the projections are constituted by the solder bumps 49, the exposure for forming both of the bonding pads 47 and the positioning pads 51 is carried out at one time by using the same mask, so an advantage that there is not caused any substantial movement between the both can be obtained.

The present invention is not limited to the above described embodiments but can be modified variously without departing from the gist of the invention.
(1) For example, the material for the circuit board can be, other than the described BT resin and epoxy resin, other resin such as polyimide, glass-epoxy, a composite material such as glass cloth, or ceramic such as alumina, AIN, glass ceramic.
(2) In the above described embodiments, it is described the case in which for positioning and mounting an integrate circuit chip (flip chip) on a flip chip mounting circuit board, projections made of resin or consisting of solder bumps are formed and bonding is made by a flip chip technology. However, this is not for the purpose of limitation but the present invention can be adopted for use in another application, for example, in the case positioning projections made of resin or consisting of solder bumps are provided for bonding a land grid array (LGA) circuit board or a ball grid array (BGA) circuit board to a printed circuit board such as a motherboard.
(3) The solder used can be a high melting point solder such as 90% Pb solder or a solder containing Ag or In, which is selected suitably depending upon usage. Further, the kind of flux contained in the solder paste can be either of R type, RMA type and RA type (in the order of from smaller to larger reducing one). Further, other than Pb-Sn solder which is so-called soft solder, Au-Sn alloy solder or Au-Si alloy solder can be used.
(4) The technology for applying solder onto the pads can be, other than a solder paste printing technology, a technology of dropping solder paste by using a dispenser, a technology of mounting preform, pellets or solder balls, etc. can be used.
(5) In each of the above described embodiments, it has been described that the flip chip is positioned by controlling the outer peripheral surface thereof by means of projections. The positioning can otherwise be made by, for example, forming holes in the flip chip and forming the projections at the corresponding positions to the holes. In this instance, the holes can be of the same size as the projections but can be of the size fairly larger than that of the projections so long as the positioning of the flip chip can be attained.

From the foregoing description, it will be understood that according to the present invention positioning of a flip chip and bonding of the same can be with ease and accuracy.

That is, by using projections formed on a circuit board for positioning of a flip chip, a costly image processor which is necessitated in the prior art can be dispensed with and therefore the cost of equipment can be reduced. Further, since a work for image processing is not needed, mounting of a flip chip, etc. can be done in a short time.

Since the flip chip is not held in the way as the prior art, i.e., in the way in which the flip chip is held in place using flux before melting of solder, movement of the flip chip never occurs even when subjected to vibrations during conveyance. For this reason, the yield rate can be improved or made higher, and the handling of the product or article before melting of the solder can be easier, thus making it possible to improve the working ability.

Since flux is not used in case of bonding of a flip chip or the like, cleaning of the flux after melting of the solder can be dispensed with, so the cost can be described by the amount corresponding to the cost of equipment for a flux cleaning machine. Further, a process step for flux cleaning can be dispensed with, so shortening of the process can be realized and the cost can be decreased further. Further, there never occurs a defective resin molding or rusting due to flux remaining unremoved, thus making it possible to make higher the yielding rate and improve the reliability.

## Claims

1. A circuit board (41) comprising:
a substrate (41a) having a main surface;
a plurality of bonding pads (47) disposed on the main surface of said substrate (41a);
a plurality of bonding solder bumps (45) formed on said bonding pads (47) for connection with terminal pads of a board (44) to be mounted on said substrate (41), respectively;
a plurality of projection pads (51) disposed on the main surface of said substrate; characterized in that
a plurality of positioning solder bumps (49) are respectively formed on said projection pads (51) for forming projections for controlling the position of a side surface of said mounted board (44) and thereby positioning said mounted board in a predetermined place on said substrate (41).

2. A circuit board according to claim 1, wherein for positioning a board (44) which is nearly rectangular when observed in a plan view,
at least two of said projections are disposed along each side of a notional rectangle so as to be adjacent to each side of said board.

3. A method of making a circuit board (41) as claimed in one of claims 1-2, said board comprising a substrate (41a) having a main surface, said method
comprising the steps of:
forming on the main surface of said substrate a plurality of bonding pads (47) for connection with terminal pads of a board (44) to be mounted on said circuit board and a plurality of projection pads (51);
disposing first masses of solder on said bonding pads (47), respectively;
disposing second masses of solder on said projection pads (51), respectively; and
melting said first and second masses of solder by heating and forming bonding solder bumps (45) on said bonding pads (47), respectively, while at the same time forming respectively positioning solder bumps (49) on said projection pads (51) for forming projections for controlling the position of a side surface of said board and thereby positioning said mounted board in a predetermined place on said substrate.

4. A method of making a circuit board as claimed in one of claims 1-2, said board comprising a substrate (41a) having a main surface; said method
comprising the steps of:
forming on the main surface of said substrate a plurality of bonding pads (47) for connection with terminal pads of a board (44) to be mounted on said circuit board and a plurality of projection pads (51) for forming thereon projections for controlling the position of a side surface of said board and thereby positioning said mounted board in a predetermined place on said substrate;
preparing an intaglio plate (27) having a plurality of depressions (29) at corresponding positions to projection pads and said bonding pads;
filling said depressions of said intaglio plate with solder paste (31) and placing said intaglio plate on the main surface of said circuit board in such a way that said depressions are aligned with said projection pads and said bonding pads; and
melting the solder paste by heating and forming positioning solder bumps (49) on said projection pads and thereby forming said projections while forming bonding solder bumps (45) on said bonding pads.

5. An assembly of a circuit board (41) according to claim 1 and a mounted board (44), wherein said mounted board is bonded to the main surface of said substrate after being positioned in place by said projections and constitutes an integral unit with said circuit board.

6. A method of making an assembly of a circuit board (41) according to claim 1 and a mounted board (44), comprising the steps of:
mounting said mounted board (44) on the main surface of said substrate while aligning said mounted board with said substrate by means of said projections;
after the step of said mounting, melting said solder bumps (45) formed on at least one of said substrate and said mounted board (44), by heating, and bonding said bonding pads (47) of said substrate and terminal pads of said mounted board (44) together.

7. A method according to claim 6, of making an assembly of a circuit board (41) and a mounted board (44), wherein said projections are made of solder and melted at the same time when said solder bumps (45) are melted.

8. A method according to claim 6, of making an assembly of a circuit board (41) and a mounted board (44), wherein said heating is performed in a nonoxidizing atmosphere.

9. A method according to claim 8, of making an assembly of a circuit board (41) and a mounted board (44), wherein said bonding of said bonding pads and said terminal pads is performed without interposing therebetween flux or solder paste containing flux.

10. A method of making a circuit board according to one of claim 1-2, comprising the steps of:
preparing a substrate (41a) having a main surface;
forming on the main surface of said substrate a plurality of bonding pads (47) for connection with terminal pads of a board to be mounted on said circuit board and a plurality of projection pads (51) for forming thereon projections for controlling the position of a side surface of said board and thereby positioning said mounted board in a predetermined place on said substrate;
preparing a masking plate (55) having a plurality of through holes (53) at corresponding positions to projection pads and said bonding pads;
printing by using said masking plate first masses of solder paste on said bonding pads and second masses of solder paste on said projection pads, respectively; and
melting said first and second masses of solder paste by heating and forming bonding solder bumps (45) on said bonding pads while at the same time forming respectively positioning solder bumps (49) on said projection pads for thereby forming projections for controlling the position of a side surface of said board and thereby positioning said board in a predetermined place on said substrate.

## Patentansprüche

1. Schaltungsplatine (41) mit:
einem Substrat (41a) mit einer Haupt-Oberfläche;
einer Vielzahl von an der Haupt-Oberfläche des Substrates angeordneten Bondingflecken (47);
einer Vielzahl von an den Bondingflecken zur Verbindung mit jeweiligen Klemmenflecken einer an dem Substrat (41) anzubringenden Platine (44) gebildeten BondingLotperlen (45);
einer Vielzahl von an der Hauptfläche des Substrats angeordneten Vorsprungflecken (51);
**dadurch gekennzeichnet daß**
eine Vielzahl von Positionierungs-Lotperlen (49) jeweils an den Vorsprungflecken (51) zum Ausbilden von Vorsprüngen zum Steuern der Position einer Seitenfläche der bestückten Platine (44) gebildet ist, um dadurch die angebrachte Platine an einem vorgegebenen Ort an dem Substrat (41) zu positionieren.

2. Schaltungsplatine nach Anspruch 1, bei der zum Positionieren einer Platine (44), die in Draufsicht gesehen nahezu rechtwinklig ist, mindestens zwei der Fortsätze längs jeder Seite eines angenommenen Rechtecks angeordnet sind, so daß sie jeder Seite der Platine benachbart sind.

3. Verfahren zum Herstellen einer Schaltungsplatine (41) nach einem der Ansprüche 1 bis 2, welche Platine ein Substrat (41a) mit einer Hauptfläche umfaßt,
wobei das Verfahren die Schritte umfaßt:
des Ausbildens einer Vielzahl von Bondingflecken (47) zur Verbindung mit Klemmenflecken einer an der Schaltungsplatine anzubringenden Platine (44) und einer Vielzahl von Vorsprungsflecken (51) an der Hauptfläche des Substrates;
des Anordnens erster Lotmassen jeweils an den Bondingflecken (47);
des Anordnens zweiter Lotmassen jeweils an den Vorsprungsflecken (51); und
des Aufschmelzens der ersten und zweiten Lotmassen durch Erwärmen, und Ausbilden von Bondinglotperlen (45) an den jeweiligen Bondingflecken (47), während gleichzeitig jeweilige Positionierungs-Lotperlen (49) an den Vorsprungsflecken (51) ausgebildet werden, um Vorsprünge zum Steuern der Position einer Seitenfläche der Platine zu bilden und dadurch die angebrachte Platine an einem vorgegebenen Ort an dem Substrat zu positionieren.

4. Verfahren zum Herstellen einer Schaltungsplatine nach einem der Ansprüche 1 bis 2, wobei die Platine ein Substrat (41a) mit einer Hauptfläche umfaßt;
und das Verfahren die Schritte umfaßt:
des Ausbildens einer Vielzahl von Bondingflecken (47) zur Verbindung mit Klemmenflecken einer an der Schaltungsplatine anzubringenden Platine (44) an der Hauptfläche des Substrates und einer Vielzahl von Vorsprungsflecken (51) zum Ausbilden von Vorsprüngen daran, um die Position einer Seitenfläche der Platine zu steuern und um dadurch die angebrachte Platine an einer vorgegebenen Stelle an dem Substrat zu positionieren;
des Vorbereitens einer Intaglio-Platte (27) mit einer Vielzahl von Vertiefungen (29) an den Vorsprungs- und den Bondingflecken entsprechenden Positionen;
des Füllens der Vertiefungen in der Intaglio-Platte mit Lotpaste (31) und des Aufsetzens der Intaglio-Platte auf die Hauptfläche der Schaltungsplatine in solcher Weise, daß die Vertiefungen mit den Vorsprungsflecken und den Bondingflecken ausgerichtet sind; und
des Schmelzens der Lotpaste durch Erwärmen und des Ausbildens von Positionierungs-Lotperlen (49) an den Vorsprungsflecken und dadurch des Ausbilden der Vorsprünge während des Ausbildens von Bondinglotperlen (45) an den Bondingflecken.

5. Anordnung aus einer Schaltungsplatine (41) gemäß Anspruch 1 und einer angebrachten Platine (44), bei der die angebrachte Platine mit der Hauptfläche des Substrats verbunden ist, nachdem sie durch die Vorsprünge an ihrer Stelle positioniert wurde und eine integrale Einheit mit der Schaltungsplatine bildet.

6. Verfahren zum Herstellen einer Anordnung aus einer Schaltungsplatine (41) gemäß Anspruch 1 und einer angebrachten Platine (44) mit den Schritten:
des Anbringens der anzubringenden Platine (44) an der Hauptfläche des Substrats unter Ausrichten der anzubringenden Platine mit dem Substrat mittels der Vorsprünge;
nach dem Schritt des Anbringens, Schmelzen der an mindestens einem der Substrate und der anzubringenden Platine (44) gebildeten Lotperlen (45) durch Aufheizen und Verbinden der Bondingflecken (47) des Substrates und der Klemmenflecken der anzubringenden Platine (44) miteinander.

7. Verfahren nach Anspruch 6 zum Herstellen einer Anordnung aus einer Schaltungsplatine (41) und einer anzubringenden Platine (44), bei der die Vorsprünge aus Lot hergestellt sind und zu der gleichen Zeit aufgeschmolzen werden, wenn die Lotperlen (45) geschmolzen werden.

8. Verfahren nach Anspruch 6 zum Herstellen einer Anordnung aus einer Schaltungsplatine (41) und einer bestückten Platine (44), bei der das Aufheizen in einer nicht oxidierenden Atmosphäre ausgeführt wird.

9. Verfahren nach Anspruch 8 zum Herstellen einer Anordnung aus einer Schaltungsplatine (41) und einer bestückten Platine (44), bei dem das Verbinden der Bondingflecken mit den Klemmenflecken ausgeführt wird, ohne Flußmittel oder Flußmittel enthaltende Lotpaste dazwischen einzusetzen.

10. Verfahren zur Herstellung einer Schaltungsplatine nach einem der Ansprüche 1 bis 2, mit den Schritten:
Vorbereiten eines Substrats (41a) mit einer Hauptfläche;
Ausbilden einer Vielzahl von Bondingflecken (47) an der Hauptfläche des Substrats zur Verbindung mit Klemmenflecken einer an der Schaltungsplatine anzubringenden Platine und einer Vielzahl von Vorsprungsflecken (51), um daran Vorsprünge zum Beeinflussen der Position einer Seitenfläche der Platine zu formen und dadurch die bestückte Platine an einer vorgegebenen Stelle an dem Substrat zu positionieren;
Vorbereitung einer Maskierungsplatte (55) mit einer Vielzahl von Durchgangsbohrungen (53) an entsprechenden Positionen zu Vorsprungsflecken und den Bondingflekken;
mit Benutzung der Maskierungsplatte, Aufdrucken erster Massen von Lotpaste jeweils an den Bondingflecken und zweiter Massen von Lotpaste an den Vorsprungsflecken; und
Aufschmelzen der ersten und der zweiten Massen von Lotpaste durch Erwärmen, und Ausbilden von Bondinglotperlen (45) an den Bondingflecken, mit gleichzeitigem Ausbilden von jeweiligen Positionierungs-Lotperlen (49) an den Vorsprungsflecken, um dadurch Vorsprünge zum Beeinflussen der Position einer Seitenfläche der Platine zu bilden und dadurch die Platine an einer vorgegebenen Stelle an dem Substrat zu positionieren.

## Revendications

1. Carte imprimée (41) comprenant :
un substrat (41a) ayant une surface principale;
un certain nombre de plages de liaison (47) disposées sur la surface principale dudit substrat (41a);
un certain nombre de bosses de soudure de liaison (45) formées sur lesdites plages de liaison (47) pour une connexion avec des plages terminales d'une carte (44) à monter sur ledit substrat (41), respectivement;
un certain nombre de plages de saillies (51) disposées sur la surface principale dudit substrat; caractérisée en ce que
un certain nombre de bosses de soudure de positionnement (49) sont respectivement formées sur lesdites plages de saillies (51) pour former des saillies pour contrôler la position d'une surface latérale de ladite carte montée (44) et positionner de la sorte ladite carte montée en un emplacement prédéterminé sur ledit substrat (41).

2. Carte imprimée selon la revendication 1, dans laquelle pour positionner une carte (44) qui est presque rectangulaire lorsqu'observée dans une vue en plan,
au moins deux des saillies précitées sont disposées le long de chaque côté d'un rectangle imaginaire afin d'être adjacentes à chaque côté de ladite carte.

3. Procédé de réalisation d'une carte imprimée (41) comme revendiquée dans l'une des revendications 1-2, ladite carte comprenant un substrat (41a) ayant une surface principale, ledit procédé comprenant les étapes de :
former sur la surface principale dudit substrat un certain nombre de plages de liaison (47) pour une connexion avec des plages terminales d'une carte (44) à monter sur ladite carte imprimée et un certain nombre de plages de saillies (51);
disposer des premières masses de soudure sur lesdites plages de liaison (47), respectivement;
disposer des secondes masses de soudure sur lesdites plages de saillies (51), respectivement; et
fondre lesdites première et seconde masses de soudure par chauffage et former des bosses de soudure de liaison (45) sur lesdites plages de liaison (47), respectivement, tout en même temps formant respectivement des bosses de soudure de positionnement (49) sur lesdites plages de saillies (51) pour former des saillies pour contrôler la position d'une surface latérale de ladite carte et positionner de la sorte ladite carte montée dans un emplacement prédéterminé sur ledit substrat.

4. Procédé pour réaliser une carte imprimée comme revendiquée dans l'une des revendications 1-2, ladite carte comprenant un substrat (41a) ayant une surface principale; ledit procédé comprenant les étapes de :
former sur la surface principale dudit substrat un certain nombre de plages de liaison (47) pour une connexion avec des plages terminales d'une carte (44) à monter sur ladite carte imprimée et un certain nombre de plages de saillies (51) pour former sur celles-ci des saillies pour contrôler la position d'une surface latérale de ladite carte et positionner de la sorte ladite carte montée en un emplacement prédéterminé sur ledit substrat;
préparer une plaque en taille douce (27) ayant un certain nombre d'enfoncements (29) à des positions correspondant aux plages de saillies et auxdites plages de liaison;
remplir lesdits enfoncements de ladite plaque en taille douce de pâte de soudure (31) et placer ladite plaque en taille douce sur la surface principale de ladite carte imprimée de telle manière que lesdits enfoncements soient alignés avec lesdites plages de saillies et lesdites plages de liaison; et
fondre la pâte de soudure par chauffage et former des bosses de soudure de positionnement (49) sur lesdites plages de saillies et former de la sorte lesdites saillies tout en formant des bosses de soudure de liaison (45) sur lesdites plages de liaison.

5. Ensemble d'une carte imprimée (41) selon la revendication 1 et une carte montée (44), dans lequel ladite carte montée est liée à la surface principale du substrat précité après avoir été positionnée en place par les saillies précitées et constitue une unité intégrale avec ladite carte imprimée.

6. Procédé de réalisation d'un ensemble d'une carte imprimée (41) selon la revendication 1 et d'une carte montée (44), comprenant les étapes de :
monter ladite carte montée (44) sur la surface principale du substrat précité tout en alignant ladite carte montée avec ledit substrat au moyen des saillies précitées;
après l'étape dudit montage, fondre les bosses de soudure précitées (45) formées sur au moins l'un dudit substrat et de ladite carte montée (44), par chauffage, et lier les plages de liaison (47) précitées du substrat et des plages terminales de ladite carte montée (44) ensemble.

7. Procédé selon la revendication 6 pour réaliser un ensemble d'une carte imprimée (41) et d'une carte montée (44), dans lequel les saillies précitées sont réalisées en soudure et fondues en même temps lorsque les bosses de soudure précitées (45) sont fondues.

8. Procédé selon la revendication 6 pour réaliser un ensemble d'une carte imprimée (41) et d'une carte montée (44), dans lequel le chauffage précité est accompli dans une atmosphère non oxydante.

9. Procédé selon la revendication 8 pour réaliser un ensemble d'une carte imprimée (41) et d'une plaque montée (44), dans lequel la liaison précitée des plages de liaison précitées et des plages terminales précitées est accomplie sans interposer entre elles un flux ou une pâte de soudure contenant un flux.

10. Procédé pour réaliser une carte imprimée selon l'une des revendications 1-2, comprenant les étapes de :
préparer un substrat (41a) ayant une surface principale;
former sur la surface principale dudit substrat un certain nombre de plages de liaison (47) pour une connexion avec des plages terminales d'une carte à monter sur ladite carte imprimée et un certain nombre de plages de saillies (51) pour former sur celles-ci des saillies pour contrôler la position d'une surface latérale de ladite carte et positionner de la sorte ladite carte montée dans un emplacement prédéterminé sur ledit substrat;
préparer une plaque de masquage (55) ayant un certain nombre de trous traversants (53) à des positions correspondant aux plages de saillies et auxdites plages de liaison;
imprimer en utilisant ladite plaque de masquage des premières masses de pâte de soudure sur lesdites plages de liaison et des secondes masses de pâte de soudure sur lesdites plages de saillies, respectivement; et
fondre lesdites première et seconde masses de pâte de soudure par chauffage et former des bosses de soudure de liaison (45) sur lesdites plages de liaison tout en formant en même temps respectivement des bosses de soudure de positionnement (49) sur lesdites plages de saillies pour former de la sorte des saillies pour contrôler la position d'une surface latérale de ladite carte et positionner de la sorte ladite carte en un emplacement prédéterminé sur ledit substrat.
